# EUROPEAN PATENT SPECIFICATION

(11) **EP 1 231 512 B1**
(45) Date of publication and mention of the grant of the patent: **04.02.2004**
(21) Application number: 01127559.1
(22) Date of filing: 19.11.2001
(51) Int. Cl.: G03F 7/09

(54) **Composition for anti-reflective coating and method for manufacturing semiconductor device**
Zusammensetzung für Antireflexionsbeschichtung und Verfahren zur Herstellung von Halbleiterbauelementen
Composition pour revêtement antiréfléchissant et méthode de fabrication d'un dispositif semi-conducteur

(30) Priority: 08.02.2001 JP 2001032918
(43) Date of publication of application: 14.08.2002
(73) Proprietor: Semiconductor Leading Edge Technologies, Inc., Ibaraki-ken, 305-0053 (JP)
(72) Inventor: Toriumi, Minoru, Totsuka-ku, Yokohama, Kanagawa 244-0817 (JP)
(74) Representative: Prüfer, Lutz H., Dipl.-Phys.

(56) References cited:
- EP-A- 0 583 918
- EP-A- 0 811 669
- EP-A- 1 138 718
- US-A- 4 910 122
- US-A- 5 356 665
- US-A- 5 443 941
- US-A- 5 728 508
- DATABASE WPI Section Ch, Week 198547 Derwent Publications Ltd., London, GB; Class A14, AN 1985-293927 XP002196688 & JP 60 203613 A (ASAHI CHEM IND CO LTD), 15 October 1985 (1985-10-15)
- DATABASE WPI Section Ch, Week 199344 Derwent Publications Ltd., London, GB; Class A14, AN 1993-348565 XP002196689 & JP 05 255527 A (NEOS KK), 5 October 1993 (1993-10-05)
- PATENT ABSTRACTS OF JAPAN vol. 2000, no. 16, 8 May 2001 (2001-05-08) & JP 2001 019895 A (NAKAE BUSSAN KK), 23 January 2001 (2001-01-23)
- PATENT ABSTRACTS OF JAPAN vol. 2000, no. 03, 30 March 2000 (2000-03-30) & JP 11 339556 A (TEIJIN LTD), 10 December 1999 (1999-12-10)
- DATABASE WPI Section Ch, Week 200016 Derwent Publications Ltd., London, GB; Class A14, AN 2000-177021 XP002196690 & JP 2000 026545 A (KANTO DENKA KOGYO KK), 25 January 2000 (2000-01-25)

## Description

### Background of the Invention

### Field of the Invention

The present invention relates to lithography technique used in the manufacturing process of semiconductor devices, and specifically to the adhesion between an anti-reflective coating and a resist film.

### Description of the Background Art

In the manufacturing process of semiconductor devices, lithography technique is used to form a resist pattern on a semiconductor substrate such as, for example, a silicon wafer.

Here, lithography technique will be described below.

First, a resist film (resist layer) is formed on a semiconductor substrate as a substrate to be processed. More specifically, there is formed an organic layer having the solubility to an alkaline solution of whose area irradiated by active beams such as ultraviolet rays changes.

Next, active beams , such as ultraviolet rays, far ultraviolet rays, excimer laser beams, X rays, and electron beams are selectively radiated onto the above-described resist film through a mask (reticle) on which a desired pattern has been formed.

Finally, the resist film is developed to form a resist pattern. In more detail, the resist film is developed using an alkaline solution to remove the area that has higher solubility to this alkaline solution (the exposed area in the case of a positive resist) leaving the area that has lower solubility. Thereby, a resist pattern is formed on the semiconductor substrate.

Next, the area on which the resist pattern has not been formed, that is the exposed surface of the substrate or the film to be processed is subjected to etching.

Then, the resist pattern is removed by plasma ashing and a chemical solution or the like. Thereby, device patterns required for various wirings, electrodes, and the like are formed.

The lithography technique presently used for mass production is photolithography technique using, for example, KrF or ArF excimer laser beams. By repeating patterning using the photolithography technique, a large number of semiconductor devices (semiconductor elements) are produced on a semiconductor substrate.

Also as the resists used in the photolithography technique include negative resists whose areas irradiated by active beams become insoluble in development, and positive resists whose areas irradiated by active beams are dissolved and removed in development, which are suitably selected according to the purpose of use.

However, in patterning using the photolithography technique, it has been known that the multiple interference of exposure light (active beams) occurs in the resist film, and the width of resist patterns varies concurrent to the variation of the thickness of the resist film.

This multiple interference is caused by the interference of exposure light incident to the resist film with reflected light from the substrate, which makes the exposure intensity uneven in the thickness direction of the resist film. Furthermore, this multiple interference affects the width of the resist pattern obtained after development, resulting in the lowered dimensional accuracy of the resist pattern.

This is particularly significant when a fine resist pattern is formed on a substrate that has difference in level. More specifically, when a resist is applied onto a substrate that has difference in level, the thickness of the resist film becomes uneven due to the difference in level, and the multiple interference of the exposure light occurs. This lowers the dimensional accuracy of the resist pattern, and the pattern with high resolution cannot be formed.

Therefore, there has been demand for the development of techniques for forming fine patterns of high dimensional accuracy even on a substrate that has difference in level.

As a means for reducing the interference of light, US Patent No. 4,910,122 proposes a method for forming an anti-reflective coating (ARC) on a substrate to be processed.

The EP-A-0 583 918 discloses an anti-reflective coating made of a fluorine-containing polymer in a solvent.

The US-A-5 728 508 discloses a method of forming a photoresist layer on a substrate, and then forming an anti-reflective film-forming material, which is a fluorinated resin, on the photoresist layer.

The US-A-5 443 941 discloses a photolitography process, wherein a fluorocarbon resin is formed in a plasma reactor on a substrate.

The anti-reflective coating is a uniform thin film that is inserted underneath the photoresist film as a photosensitive layer, and contains a light absorbing dye. The anti-reflective coating absorbs the light reflected form the substrate, and facilitates fine photosensitive film patterns (resist patterns) to be formed at high dimensional accuracy. Many types of anti-reflective coatings are available in the market.

In resent years, the wavelength of light used in the photolithography technique has become shorter concurrent with reduction in the size of device patterns. Specifically, the lithography technique using F₂ excimer laser of a wavelength of 157 nm as the light source has been examined actively.

However, since ordinary substances absorb much light having vacuum ultraviolet wavelengths as short as 157 nm, there has been a problem that conventional photoresist materials cannot be used.

In order to solve this problem, a photoresist composition that contains a fluorocarbon resin having high transparency to the light source of short wavelengths (hereafter called "fluorocarbon-resin-based resist") is proposed.

However, the fluorocarbon-resin-based resist has a problem of poor adhesion to ordinary anti-reflective coatings. Here, the ordinary anti-reflective coatings means phenolic-resin-based anti-reflective coatings or the like.

Therefore, there is a problem that the fluorocarbon-resin-based resist cannot be applied onto the anti-reflective coating.

Also there is another problem that the fluorocarbon-resin-based resist is separated from the anti-reflective coating during development.

Therefore, the fluorocarbon-resin-based resist cannot be formed on the anti-reflective coating with good adhesion. Thus, there is a problem that the fluorocarbon-resin-based resist cannot be used in the lithography technique using F₂ excimer laser as the light source.

### SUMMARY OF THE INVENTION

The present invention has been conceived to solve the previously-mentioned problems and a general object of the present invention is to provide a novel and useful composition for forming an anti-reflective coating and to provide a novel and useful method for manufacturing a semiconductor device.

A more specific object of the present invention is to provide a composition for anti-reflective coatings that excels in adhesion to fluorocarbon-resin-based resists and is to form fine resist patterns by applying a fluorocarbon-resin-based resist to the photolithography technique.

The above object of the present invention is attained by a use as defined in claim 1 and by a method of manufacturing a semiconductor device as defined in claim 7. Preferred embodiments are defined in the sub-claims.

Other objects and further features of the present invention will be apparent from the following detailed description when read in conjunction with the accompanying drawings.

### BRIEF DESCRIPTION OF THE DRAWINGS

Figs. 1A to 1C are cross-sectional views for describing a method for manufacturing a semiconductor device according to a first embodiment of the present invention; and
Figs. 2A to 2E are cross-sectional views for describing a method for manufacturing a semiconductor device according to a second embodiment of the present invention.

### DETAILED DESCRIPTION OF THE PREFERRED EMBODIMENTS

In the following, principles and embodiments of the present invention will be described with reference to the accompanying drawings. The members and steps that are common to some of the drawings are given the same reference numerals and redundant descriptions therefore may be omitted.

### First Embodiment

A composition for anti-reflective coatings used according to a first embodiment of the present invention will be described below.

The composition for anti-reflective coatings used according to the first embodiment comprises a polymer that contains fluorine, and a solvent that dissolves the polymer.

First, the polymer that contains fluorine will be described.

The polymer contains at least one of fluorocarbon resins, polyimides containing fluorine, acrylic polymers containing fluorine, and polymers containing fluorine and having an alicyclic structure. The methods for manufacturing the polymer are methods known to public or known to those skilled in the art.

Here, the fluorocarbon resins are formed by homo-polymerizing or co-polymerizing monomers that contain fluorine.

The monomers that contain fluorine include fluoroolefines and fluorovinylether. Specifically, preferable monomers are tetrafluoroethylene, trifluoroethylene, hexafluoropropylene, perfluoroalkyl vinylethers (e.g., perfluoromethyl vinylether and perfluoropropyl vinylether), and perfluorovinylether. Furthermore, perfluorovinylether having functional groups such as a carboxylic group (-COOH group) and a sulfonic group (-SO₂OH group) are also preferable monomers.

In addition, the examples of preferable monomers include vinylidene fluoride, vinyl fluoride, and chlorofluoroolefines such as chlorotrifluoroethylene.

Such monomers are polymerized alone, or in combination. Furthermore, the monomers may be copolymerized with other monomers unless the nature of such monomers is lost. Here, the other monomers to be copolymerized are not limited to specific monomers as long as the monomers are susceptible to radical polymerization, and include monomers that contain fluorine as described above, or hydrocarbon-based monomers. Furthermore, the polymer that contains fluorine and has an alicyclic structure can be formed by polymerizing one of these other monomers alone, or by radical-copolymerizing with a monomer that can introduce a specific ring structure. Also, two or more other monomers may be radical-copolymerized in combination.

The polymer contains preferably 10% by weight or more fluorine atoms, more preferably 40% by weight or more fluorine atoms. If the fluorine content of the polymer is too low, the unique characteristics of the fluorine atom is hardly exerted. The unique characteristics used herein are the characteristics of fluorine that affect the adhesion of the anti-reflective coating and the resist film, which will be described later.

The fluorocarbon resin may be a mixture with other resins. The other resins include, for example, novolak-based resins, polyvinylphenol-based resins, the mixture of these resins, or copolymers that contain at least one of these resins.

The fluorocarbon resin may be adequately cross-linked. Thereby, the reaction between the anti-reflective coating and the resist composition can be prevented when the resist composition is applied onto the anti-reflective coating, and the formation of a mixing layer at the interface between the anti-reflective coating and the resist composition can be prevented. Also, cross-linking may control etching resistance depending on process conditions.

The method for cross-linking may be the one normally practiced. For example, a method by copolymerizing monomers having cross-linking sites, a method by adding a cross-linking agent, or a method using radioactive rays. Polymers other than fluorocarbon resins, namely polyimides containing fluorine, acrylic copolymers containing fluorine, or polymers containing fluorine and having an alicyclic structure, may also be cross-linked.

Next, the solvent will be described.

The solvent is adopted to dissolve the polymer, and include at least one of alcohols, aromatic hydrocarbons, ketones, esters, chlorofluorocarbons, and super pure water.

Next, a method for manufacturing a semiconductor device comprising the process for forming an anti-reflective coating using the above-described composition for anti-reflective coatings will be described.

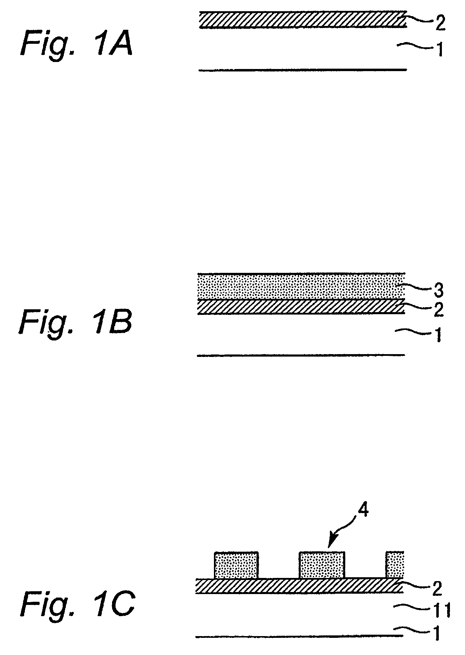

Figs. 1A to 1C are cross-sectional views for describing a method for manufacturing a semiconductor device according to a first embodiment of the present invention.

First, as shown in Fig. 1A, the above-described composition for anti-reflective coatings is spin-coated on a semiconductor substrate 1. Before applying the composition for anti-reflective coatings, the surface of the semiconductor substrate may be treated with HMDS (hexamethyldisilazane) (refer to a second embodiment for details).

Next, in order to remove the solvent contained in the composition for anti-reflective coatings, heat treatment (heat drying process) is performed. Thereby, an anti-reflective coating 2 is formed on a semiconductor substrate 1. The heat treatment is preferably performed within a temperature range between 100°C and 250°C for 30 seconds to 60 minutes.

It is preferable, from the point of view of functions (optical characteristics), that the thickness of the anti-reflective coating 2 after the heat treatment is 150 nm or less.

Although the heat treatment is performed in the air or in a nitrogen atmosphere, it may also be performed in an oxygen atmosphere. If the heat treatment is performed in the oxygen atmosphere, the anti-reflective coating is oxidized, and the index of refraction changes, whereby the index of refraction of the anti-reflective coating can be controlled.

Here, as is well known, it is preferable that the index of refraction of the anti-reflective coating is agreed with the index of refraction of the photoresist film that will be described later. However, it is not necessary to entirely agree the indices of refraction of the anti-reflective coating and the photoresist film as long as the reflectance R of the anti-reflective coating is 10% or less.

Also in order to agree the index of refraction of the anti-reflective coating with the index of refraction of an ordinary photoresist, it is preferable that the real part value of the complex index of refraction of the anti-reflective coating is within a range 1.0 < n < 3.0, and the imaginary part value is within a range 0.4 < k < 1.3.

The index of refraction of the anti-reflective coating can be controlled by any well-known methods. Such methods include, for example, a method for lowering the index of refraction by introducing fluorine atoms in the composition for anti-reflective coatings, or a method for elevating the index of refraction by introducing a colorant that absorbs light of desired wavelengths.

Next, as shown in Fig. 1B, a photoresist film that contains fluorine (hereafter called "a fluorocarbon-resin-based resis"t) 3 is formed on the anti-reflective coating 2.

Then, the resist film 3 is exposed to an F₂ excimer laser as a light source, and is developed. Thereby, a resist pattern 4 as shown in Fig. 1C is formed.

As described above, the composition for anti-reflective coatings according to the first embodiment comprises a polymer that contains fluorine, and a solvent that dissolve the polymer.

The anti-reflective coating 2 formed by using this composition for anti-reflective coatings has a high adhesiveness to the fluorocarbon-resin-based resist 3. Therefore, the occurrence of resist pattern separation or resist pattern falling can be prevented at the interface with the anti-reflective coating 2.

Therefore, since the fluorocarbon-resin-based resist, from which high resolution can be expected, can be applied to the photolithography technique, a fine resist pattern 4 can be formed.

Although a fluorocarbon-resin-based resist is used as the photoresist film 3 in the first embodiment, the resist may be selected optionally from generally used positive or negative types of photoresist, and the optimal resist can be selected depending on the dimension, required accuracy, and the characteristics of exposing system.

Also in the first embodiment, although the anti-reflective coating 2 is formed directly on a semiconductor substrate 1, the anti-reflective coating is normally formed on a film to be processed, such as an insulating film or a metal film, formed on the semiconductor substrate. Therefore, fine device patterns can be formed by etching the insulating film or the metal film using fine resist patterns 4 as masks.

Also, the present invention is not limited to the application to semiconductor-substrates such as a silicon substrate, but also can be applied to insulating substrates such as a quartz substrate and a ceramic substrate. (This is also applied to a second embodiment through a sixth embodiment, which will be described later.)

### Second Embodiment

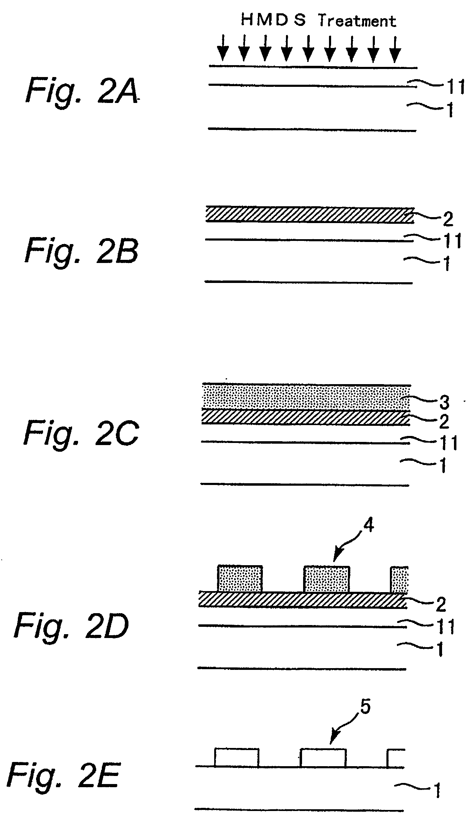

Figs. 2A to 2E are cross-sectional views for describing a method for manufacturing a semiconductor device according to a second embodiment of the present invention. A method for manufacturing a semiconductor device according to a second embodiment will be described below referring to Fig. 2.

First, as shown in Fig. 2A, the surface of a film to be processed 11 formed on a semiconductor substrate 1 is treated with HMDS (hexamethyldisilazane) at a temperature of 110°C for 60 seconds. The HMDS treatment is performed for improving adhesion between the film to be processed 11 on the semiconductor substrate 1 and the anti-reflective coating 2 (described later). More specifically, HMDS [chemical formula : (CH₃)₃SiNHSi(CH₃)₃] used as a adhesion enhancing agent is vaporized to coat the film to be processed 11 on the semiconductor substrate 1.

Next, the composition for anti-reflective coatings is spin-coated on the f ilm to be processed 11 treated with HMDS. The composition for anti-reflective coatings used herein is a butyl acetate solution containing 1 g of the copolymer of tetrafluoroethylene and propylene as the polymer, and 10 g of butyl acetate as the solvent.

Next, the semiconductor substrate 1 is heat-treated at a temperature of 180°C for 60 seconds. Thereby, as shown in Fig. 2B, an anti-reflective coating 2 of a thickness of 80 nm is formed on the film to be processed 11.

Next, a fluorine-containing resist composition (fluorocarbon-resin-based resist) containing, for example, tetrafluoroethylene is spin-coated on the anti-reflective coating 2.

Then, the semiconductor substrate 1 is heat-treated at a temperature of 120°C for 60 seconds. Thereby, as shown in Fig. 2C, a resist film 3 of a thickness of 200 nm is formed.

Next, the resist film 3 is exposed to ultraviolet rays of a wavelength of 157 nm from F₂ excimer laser exposing system.

Then, the resist film 3 is developed using an alkaline developer. Thereby, as shown in Fig. 2D, fine resist patterns 4 are formed.

Next, the film to be processed 11 is subjected to dry etching using the resist patterns 4 as masks. Then, the resist pattern 4 is removed. Thereby, fine device patterns 5 are formed. In this dry etching, the anti-reflective coating 2 is first etched.

As described above, in the method for manufacturing a semiconductor device according to the second embodiment, the composition for anti-reflective coating comprising the polymer that contains fluorine is applied onto the film to be processed 11 formed on the semiconductor substrate 1 to form the anti-reflective coating 2. Then, the resist composition that contains fluorine is applied onto the anti-reflective coating 2 to form the resist film 3. Furthermore, exposure light is radiated on the resist film 3 to form the resist patterns 4.

According to the above-described manufacturing method, since both the anti-reflective coating 2 and the resist patterns 4 contain fluorine, excellent adhesiveness is obtained. Therefore, the separation and falling of resist patterns at the interface with the anti-reflective coating can be prevented.

Therefore, since a fluorocarbon-resin-based resist suitable for F₂ excimer laser can be applied to the photolithography technique, fine resist patterns 4 can be formed.

In addition, by etching using such fine resist patterns 4, fine device patterns 5 can be formed. That is, the size of device patterns of a semiconductor device can be reduced.

In the second embodiment, the resist film 3 is exposed to ultraviolet rays having a wavelength of 157 nm from F₂ excimer laser exposing system, but the same effect was obtained when the resist film was exposed to ultraviolet rays having a wavelength of 193 nm from ArF excimer laser exposing system. That is, the obtained fluorocarbon-resin-based resist patterns were fine patterns without separation or falling at the interface with the anti-reflective coating.

In the second embodiment, although the copolymer of tetrafluoroethylene and propylene is used as the fluorine-containing polymer in the composition for anti-reflective coatings, the second embodiment is not limited to this, but the polymer described in the first embodiment can also be used. (This is also applied to the following embodiments.)

The following experiments 1 and 2 were conducted to verify the effects in the second embodiment.

### (Experiment 1)

First, the surface of a semiconductor substrate was subject to the above-described HMDS treatment.

Next, without forming an anti-reflective coating, the above-described fluorine-containing resist composition that contains tetrafluoroethylene was spin-coated on the semiconductor substrate.

In Experiment 1, however, the resist composition was repelled on the semiconductor substrate, and it was difficult to apply the resist composition evenly with spin coating. Therefore, fine resist patterns could not be formed using the fluorine-containing resist composition.

### (Experiment 2)

After the HMDS treatment, an anti-reflective coating is formed using a phenolic-resin-based composition for anti-reflective coatings without containing fluorine in place of the composition for anti-reflective coatings used in the second embodiment.

Next, the fluorine-containing resist composition that contains tetrafluoroethylene used in the second embodiment is spin-coated on the anti-reflective coatings.

However, the resist composition is repelled on the anti-reflective coatings, and it is difficult to apply the resist composition evenly with spin coating.

Furthermore, although the process is continued to pattern exposure, the fine resist patterns obtained after developing separated and fell down at the interface with the anti-reflective coatings. Therefore, the fluorocarbon-resin-based photoresist could not be applied to the manufacture of semiconductor devices.

### Third Embodiment

A method for manufacturing a semiconductor device according to a third embodiment is the same as the method for manufacturing a semiconductor device according to the above-described second embodiment, except for a composition for anti-reflective coatings, and a heat treatment performed after the application of the composition for anti-reflective coatings.

The description below will be focused on these differences, and the descriptions of items overlapping the items in the second embodiment will be omitted.

First, a composition for anti-reflective coatings according to the third embodiment will be described.

The composition for anti-reflective coatings according to the third embodiment is an water-based dispersion of a solid content of 10% by weight, comprising a fluorine-containing polymer consisting of a copolymer (ionic emulsifier) of tetrafluoroethylene, hexafluoropropylene, and vinylidene chloride, and a solvent consisting of super pure water.

Next, a method for manufacturing a semiconductor device using the above-described composition for anti-reflective coatings will be described.

First, the surface of a semiconductor substrate is treated with HMDS.

Next, the above-described water-based dispersion as a composition for anti-reflective coatings is spin-coated on the semiconductor substrate.

Then, the semiconductor substrate is subjected to heat treatment at a temperature of 150°C for 30 minutes. Thereby, an anti-reflective coating of a thickness of 100 nm is formed on the semiconductor substrate.

Thereafter, resist patterns are formed in the same manner as in the second embodiment.

As described above, in the method for manufacturing a semiconductor device according to the third embodiment, the anti-reflective coating was formed through the use of the composition for anti-reflective coatings comprising polymer that contains fluorine, and fluorocarbon-resin-based resist patterns were formed on the anti-reflective coating.

According to this manufacturing method, the same effect as in the second embodiment can be obtained.

Furthermore, the dimensional variation, which was about ±50 nm when the composition for anti-reflective coatings according.to the third embodiment is not used, could be reduced to about ±20 nm. That is, the resist patterns could be formed in high accuracy.

### Fourth Embodiment

A method for manufacturing a semiconductor device according to a fourth embodiment is the same as the method for manufacturing a semiconductor device according to the above-described second embodiment, except for a composition for anti-reflective coatings, and a heat treatment performed after the application of the composition for anti-reflective coatings.

The description below will be focused on these differences, and the description of items overlapping the items in the second embodiment will be omitted.

First, a composition for anti-reflective coatings according to a fourth embodiment will be described.

The composition for anti-reflective coatings according to the fourth embodiment is a butyl acetate solution of a solid content of 5%, comprising a polymer of vinylidene fluoride as a fluorine-containing polymer, and butyl acetate as a solvent.

Next, a method for manufacturing a semiconductor device using the above-described composition for anti-reflective coatings will be described.

First, the surface of a semiconductor substrate is treated with HMDS.

Next, the above-described butyl acetate solution as the composition for anti-reflective coatings is spin-coated on the semiconductor substrate.

Then, the semiconductor substrate is subjected to heat treatment at a temperature of 160°C for 60 minutes. Thereby, an anti-reflective coating of a thickness of 100 nm is formed on the semiconductor substrate.

Thereafter, resist patterns are formed in the same manner as in the second embodiment.

As described above, in the method for manufacturing a semiconductor device according to the fourth embodiment, the anti-reflective coating was formed through the use of the composition for anti-reflective coatings comprising the polymer that contains fluorine (vinylidene fluoride polymer), and fluorocarbon-resin-based resist patterns were formed on the anti-reflective coating.

According to this manufacturing method, the same effect as in the second embodiment can be obtained.

### Fifth Embodiment

A method for manufacturing a semiconductor device according to a fifth embodiment is the same as the method for manufacturing a semiconductor device according to the above-described second embodiment, except for a composition for anti-reflective coatings, and a heat treatment performed after the application of the composition for anti-reflective coatings.

The description below will be focused on these differences, and the description of items overlapping the items in the second embodiment will be omitted.

First, a composition for anti-reflective coatings according to a fifth embodiment will be described.

The composition for anti-reflective coatings according to the fifth embodiment is a mixed solution obtained by mixing and stirring a polymer that contains fluorine consisting of 10 g of a copolymer of fluoroethylene and vinyl ether, 2 g of an isocyanate-based hardening agent, and 40 g of xylene, and a solvent consisting of 120 g of methyl-iso-butyleketone.

Next, a method for manufacturing a semiconductor device using the above-described composition for anti-reflective coatings will be described.

First, the surface of a semiconductor substrate is treated with HMDS.

Next, the above-described mixed solution as the composition for anti-reflective coatings is spin-coated on the semiconductor substrate.

Then, the semiconductor substrate is subjected to heat treatment at a temperature of 180°C for 2 minutes. Thereby, an anti-reflective coating of a thickness of 100 nm is formed on the semiconductor substrate.

Thereafter, resist patterns are formed in the same manner as in the second embodiment.

As described above, in the method for manufacturing a semiconductor device according to the fifth embodiment, the anti-reflective coating was formed through the use of the composition for anti-reflective coatings comprising the polymer that contains fluorine, and fluorocarbon-resin-based resist patterns were formed on the anti-reflective coating.

According to this manufacturing method, the same effect as in the second embodiment can be obtained.

The isocyanate-based hardening agent contained in the composition for anti-reflective coatings prevents the anti-reflective coating from reacting with the resist composition, when the resist composition is applied onto the anti-reflective coating. Therefore, the formation of a mixed layer at the interface between the anti-reflective coating and the resist film can be prevented, whereby the accuracy of exposure can be improved.

Furthermore, by adjusting the quantity of the isocyanate-based hardening agent added to the composition for anti-reflective coatings, the etching resistance of the anti-reflective coating can be controlled.

### Sixth Embodiment

A method for manufacturing a semiconductor device according to a sixth embodiment is the same as the method for manufacturing a semiconductor device according to the above-described second embodiment, except for a composition for anti-reflective coatings, and a heat treatment performed after the application of the composition for anti-reflective coatings.

The description below will be focused on these differences, and the description of items overlapping the items in the second embodiment will be omitted.

First, a composition for anti-reflective coatings according to a sixth embodiment will be described.

The composition for anti-reflective coatings according to the sixth embodiment is a methanol solution of a solid content of 5%, comprising a polymer that contains fluorine consisting of a copolymer of perfluoro-(butenylvinylether) and hydroxyperfluoro-(4-vinyloxybutanoate), and a solvent consisting of methanol.

Next, a method for manufacturing a semiconductor device using the above-described composition for anti-reflective coatings will be described.

First, the surface of a semiconductor substrate is treated with HMDS.

Next, the above-described methanol solution as a composition for anti-reflective coatings is spin-coated on the semiconductor substrate.

Then, the semiconductor substrate is subjected to heat treatment at a temperature of 120°C for 5 minutes. Thereby, an anti-reflective coating of a thickness of 100 nm is formed on the semiconductor substrate.

Thereafter, resist patterns are formed in the same manner as in the second embodiment.

As described above, in the method for manufacturing a semiconductor device according to the sixth embodiment, the anti-reflective coating was formed through the use of the composition for anti-reflective coatings comprising the polymer that contains fluorine, and fluorocarbon-resin-based resist patterns were formed on the anti-reflective coating.

According to this manufacturing method, the same effect as in the second embodiment can be obtained.

Furthermore, the dimensional variation, which was about ±50 nm when the composition for anti-reflective coatings according to Sixth Embodiment is not used, could be reduced to about ±20 nm. That is, the resist patterns could be formed in high accuracy.

This invention, when practiced illustratively in the manner described above, provides the following major effects:

According to the present invention, an anti-reflective coating that excels in adhesiveness to the photoresist can be used, even if a fluorocarbon-resin-based photoresist is used. Also, a fluorocarbon-resin-based photoresist can be applied to the photolithography technique to form fine resist patterns.

Further, the present invention is not limited to these embodiments, but variations and modifications may be made.

## Claims

1. Use of a composition for forming an anti-reflective coating (2) on a semiconductor substrate (1) or a film to be processed (11), comprising:
a polymer containing fluorine; and
a solvent for dissolving said polymer;
in combination, with a resist film that contains fluorine (3) to be formed on said anti-reflective coating (2).

2. The use according to claim 1,
wherein said polymer comprised in said polymer containing fluorine contains at least one of polyimides, acrylic polymers, polymers having an alicyclic structure and fluorocarbon resins formed by homo-polymerizing or co-polymerizing fluorine-containing monomers.

3. The use according to claim 2,
wherein the fluorine-containing monomers comprise at least one of fluoroolefines, fluorovinylether, vinylidene fluoride, vinyl fluoride, chlorofluoroolefines, and fluorovinylether having carboxylic groups or sulfonic groups.

4. The use according to any one of claims 1 to 3,
wherein said polymer comprised in said polymer containing fluorine contains 10% by weight or more fluorine atoms.

5. The use according to any one of claims 1 to 4,
wherein said polymer comprised in said polymer containing fluorine has a cross-linked structure.

6. The use according to any one of claims 1 to 5,
wherein said solvent comprises at least one of alcohols, aromatic hydrocarbons, ketones, esters, chlorofluorocarbons, and super pure water.

7. A method for manufacturing a semiconductor device, comprising:
an anti-reflective coating forming step for forming an anti-reflective coating (2) by coating a composition for an anti-reflective coating, wherein the composition comprises a polymer containing fluorine, and a solvent for dissolving said polymer, on a semiconductor substrate (1) or a film to be processed (11);
a resist film forming step for forming a resist film containing fluorine (3) on the anti-reflective coating (2) formed in said anti-reflective coating forming step; and
an exposure step for radiating exposure light onto the resist film formed in said resist film forming step.

8. The method for manufacturing a semiconductor device according to claim 7, wherein said composition for an anti-reflective coating is as defined in any one of claims 2 to 6.

9. The method for manufacturing a semiconductor device according to claim 7 or 8,
wherein said anti-reflective coating forming step comprises a heating step for heating the semiconductor substrate (1) on which the anti-reflective coating (2) is formed.

10. The method for manufacturing a semiconductor device according to claim 9,
wherein said heating step is performed at a temperature between 100°C and 250°C for 30 seconds to 60 minutes.

11. The method for manufacturing a semiconductor device according to claim 9 or 10,
wherein said heating step is performed in an oxygen atmosphere.

12. The method for manufacturing a semiconductor device according to any one of claims 9 to 11,
wherein the thickness of the anti-reflective coating (2) is made 150 nm or less in said heating step.

13. The method for manufacturing a semiconductor device according to any one of claims 7 to 12,
wherein the wavelength of the exposure light radiated in said exposure step is 254 nm or less.

## Patentansprüche

1. Verwendung einer Zusammensetzung zum Bilden einer Antireflexionsbeschichtung (2) auf einem Halbleitersubstrat (1) oder einem zu prozessierenden Film (11), umfassend:
ein Fluor enthaltendes Polymer; und
ein Lösungsmittel zum Auflösen des Polymers;
in Verbindung mit einem Resistfilm (3), der Fluor enthält, der auf der Antireflexionsbeschichtung (2) zu bilden ist.

2. Verwendung gemäß Anspruch 1, wobei das Polymer, das in dem Fluor enthaltenden Polymer umfaßt ist, mindestens ein Polymer aus Polyimiden, Acrylpolymeren, Polymeren mit einer alizyklischen Struktur und Fluorkohlenwasserstoffharzen, die durch Homopolymerisation oder Copolymerisation von Fluor-haltigen Monomeren gebildet sind, enthält.

3. Verwendung gemäß Anspruch 2, wobei die Fluor-haltigen Monomere mindestens eines aus Fluorolefinen, Fluorvinylether, Vinylidenfluorid, Vinylfluorid, Chlorfluorolefinen und Fluorvinylether mit Carboxylgruppen oder Sulfongruppen umfaßt.

4. Verwendung gemäß irgendeinem der Ansprüche 1 bis 3, wobei das Polymer, das in dem Fluor enthaltenden Polymer umfaßt ist, 10 Gew.-% oder mehr Fluoratome enthält.

5. Verwendung gemäß irgendeinem der Ansprüche 1 bis 4, wobei das Polymer, welches in dem Fluor enthaltenden Polymer umfaßt ist, eine quervernetzte Struktur aufweist.

6. Verwendung gemäß irgendeinem der Ansprüche 1 bis 5, wobei das Lösungsmittel mindestens eines aus Alkoholen, aromatischen Kohlenwasserstoffen, Ketonen, Estern, Chlorfluorkohlenstoffen und superreinem Wasser umfaßt.

7. Verfahren zum Herstellen einer Halbleitervorrichtung, umfassend:
einen Antireflexionsbeschichtungsbildungsschritt zum Bilden einer Antireflexionsbeschichtung (2) durch Schichten einer Zusammensetzung für eine Antireflexionsbeschichtung, wobei die Zusammensetzung ein Fluor enthaltendes Polymer und ein Lösungsmittel zum Auflösen des Polymers umfaßt, auf einem Halbleitersubstrat (1) oder einem zu prozessierenden Film (11);
einen Resistfilmbildungsschritt zum Bilden eines Fluor enthaltenden Resistfilms (3) auf der Antireflexionsbeschichtung (2), die in dem Antireflexionsbeschichtungsbildungsschritt gebildet wurde; und
einen Bestrahlungsschritt zum Einstrahlen von Bestrahlungslicht auf den Resistfilm, der in dem Resistfilmbildungsschritt gebildet wurde.

8. Verfahren zum Herstellen einer Halbleitervorrichtung gemäß Anspruch 7, wobei die Zusammensetzung für eine Antireflexionsbeschichtung wie in irgendeinem der Ansprüche 2 bis 6 definiert ist.

9. Verfahren zum Herstellen einer Halbleitervorrichtung gemäß Anspruch 7 oder 8, wobei der Antireflexionsbeschichtungsbildungsschritt einen Erwärmungsschritt zum Erwärmen des Halbleitersubstrats (1) umfaßt, auf dem die Antireflexionsbeschichtung (2) gebildet ist.

10. Verfahren zum Herstellen einer Halbleitervorrichtung gemäß Anspruch 9, wobei der Erwärmungsschritt bei einer Temperatur zwischen 100°C und 250°C für 30 Sekunden bis 60 Minuten ausgeführt wird.

11. Verfahren zum Herstellen einer Halbleitervorrichtung gemäß Anspruch 9 oder 10, wobei der Erwärmungsschritt in einer Sauerstoffatmosphäre ausgeführt wird.

12. Verfahren zur Herstellung einer Halbleitervorrichtung gemäß irgendeinem der Ansprüche 9 bis 11, wobei in dem Erwärmungsschritt die Dicke der Antireflexionsbeschichtung (2) auf 150 nm oder weniger gebracht wird.

13. Verfahren zum Herstellen einer Halbleitervorrichtung gemäß irgendeinem der Ansprüche 7 bis 12, wobei die Wellenlänge des in dem Bestrahlungsschritt eingestrahlten Bestrahlungslichts 254 nm oder weniger beträgt.

## Revendications

1. Utilisation d'une composition pour former un revêtement antiréfléchissant (2) sur un substrat semiconducteur (1) ou un film à traiter (11), comprenant :
un polymère contenant du fluor ; et
un solvant pour dissoudre ledit polymère ;
en combinaison avec un film de résist qui contient du fluor (3) qui doit être formé sur ledit revêtement antiréfléchissant (2).

2. Utilisation selon la revendication 1 où ledit polymère compris dans ledit polymère contenant du fluor contient au moins une substance parmi les polyimides, les polymères acryliques, les polymères ayant une structure alicyclique et les résines fluorocarbonées formées par homopolymérisation ou copolymérisation de monomères contenant du fluor.

3. Utilisation selon la revendication 2 où les monomères contenant du fluor comprennent au moins une substance parmi les fluorooléfines, un fluorovinyléther, le fluorure de vinylidène, le fluorure de vinyle, les chlorofluorooléfines et un fluorovinyléther ayant des groupes carboxyliques ou des groupes sulfoniques.

4. Utilisation selon l'une quelconque des revendications 1 à 3 où ledit polymère compris dans ledit polymère contenant du fluor contient 10 % en masse ou plus d'atomes de fluor.

5. Utilisation selon l'une quelconque des revendications 1 à 4 où ledit polymère compris dans ledit polymère contenant du fluor a une structure réticulée.

6. Utilisation selon l'une quelconque des revendications 1 à 5 où ledit solvant comprend au moins une substance parmi les alcools, les hydrocarbures aromatiques, les cétones, les esters, les chlorofluorocarbures et l'eau extra-pure.

7. Procédé de fabrication d'un dispositif semiconducteur comprenant :
une étape de formation de revêtement antiréfléchissant pour former un revêtement antiréfléchissant (2) par application en revêtement d'une composition pour un revêtement antiréfléchissant, où la composition comprend un polymère contenant du fluor, et un solvant pour dissoudre ledit polymère, sur un substrat semiconducteur (1) ou un film à traiter (11) ;
une étape de formation de film de résist pour former un film de résist contenant du fluor (3) sur le revêtement antiréfléchissant (2) formé dans ladite étape de formation de revêtement antiréfléchissant ; et
une étape d'exposition pour projeter de la lumière d'exposition sur le film de résist formé dans ladite étape de formation de film de résist.

8. Procédé de fabrication d'un dispositif semiconducteur selon la revendication 7 où ladite composition pour un revêtement antiréfléchissant est telle que définie dans l'une quelconque des revendications 2 à 6.

9. Procédé de fabrication d'un dispositif semiconducteur selon la revendication 7 ou 8
où ladite étape de formation de revêtement antiréfléchissant comprend une étape de chauffage pour chauffer le substrat semiconducteur (1) sur lequel le revêtement antiréfléchissant (2) est formé.

10. Procédé de fabrication d'un dispositif semiconducteur selon la revendication 9
où ladite étape de chauffage est accomplie à une température entre 100°C et 250°C pendant 30 secondes à 60 minutes.

11. Procédé de fabrication d'un dispositif semiconducteur selon la revendication 9 ou 10
où ladite étape de chauffage est accomplie dans une atmosphère d'oxygène.

12. Procédé de fabrication d'un dispositif semiconducteur selon l'une quelconque des revendications 9 à 11
où l'épaisseur du revêtement antiréfléchissant (2) amenée à 150 nm ou moins dans ladite étape de chauffage.

13. Procédé de fabrication d'un dispositif semiconducteur selon l'une quelconque des revendications 7 à 12
où la longueur d'onde de la lumière d'exposition projetée dans ladite étape d'exposition est 254 nm ou moins.
